# EUROPÄISCHE PATENTSCHRIFT

(11) **EP 0 951 691 B1**
(45) Veröffentlichungstag und Bekanntmachung des Hinweises auf die Patenterteilung: **10.10.2001**
(21) Anmeldenummer: 98904010.0
(22) Anmeldetag: 07.01.1998
(51) Int. Cl.: G06K 19/077

(54) **CHIPKARTE**
CHIP CARD
CARTE A PUCE

(30) Priorität: 15.01.1997 DE 19701167
(43) Veröffentlichungstag der Anmeldung: 27.10.1999
(73) Patentinhaber: Infineon Technologies AG, 81669 München (DE)
(72) Erfinder: FRIES, Manfred, D-94336 Hunderdorf (DE); PÜSCHNER, Frank, D-93309 Kehlheim (DE); MUNDIGL, Josef, D-93182 Dugendorf (DE); FISCHER, Jürgen, D-93180 Deuerling (DE); HOUDEAU, Detlef, D-84085 Langquaid (DE)
(74) Vertreter: Hanke, Hilmar, Dipl.-Ing.
(86) Internationale Anmeldenummer: DE9800033
(87) Internationale Veröffentlichungsnummer: WO9832099

(56) Entgegenhaltungen:
- WO-A-96/07985
- DE-A- 4 431 605
- DE-A- 4 437 721
- PATENT ABSTRACTS OF JAPAN vol. 096, no. 012, 26.Dezember 1996 & JP 08 202844 A (NIPPON RETSUKU KK), 9.August 1996,

## Beschreibung

Die Erfindung betrifft eine Chipkarte mit einem Kartenträger, auf dem eine Datenverarbeitungsschaltung sowie eine Verbindungsbaugruppe zur kontaktlosen Übermittlung von Daten zwischen der Datenverarbeitungsschaltung und einer externen Datenverarbeitungsstation vorgesehen sind.

Eine gattungsgemäße Chipkarte und eine externe Datenverarbeitungsstation bilden ein Datensystem, das zur Abrechnung bargeldloser Einkäufe, zur Überwachung von Personenverkehr oder zur einfachen Gebührenverwaltung beim Zugriff auf ein Telefonnetz verwendet wird. Dazu erhält ein Benutzer eine Chipkarte, auf der eine Datenverarbeitungsschaltung vorgesehen ist, die aus einem Mikroprozessor besteht. Zur Übermittlung von Daten zwischen der Datenverarbeitungsschaltung und der externen Datenverarbeitungsstation wird bei kontaktiosen Übertragungsverfahren ein von der externen Datenverarbeitungsstation erzeugtes Wechselfeld von der Chipkarte moduliert. Dabei wird beispielsweise eine in der Verbindungsbaugruppe vorgesehene Chipkarten-Spule auf zeitlich veränderliche Weise kapazitiv oder resistiv belastet, so daß sich deren elektromagnetische Eigenschaften verändern. Dies wirkt auf eine Stations-Spule in der externen Datenverarbeitungsstation zurück. Aus der Rückwirkung kann auf in der Datenverarbeitungsschaltung abgespeicherte Daten zurückgeschlossen werden.

Die gattungsgemäße Chipkarte ist als Kunststoffkarte ausgebildet, die so groß ausgeführt ist, daß sie beispielsweise in einer Geldbörse sicher verstaut werden kann. Bei der Herstellung der gattungsgemäßen Chipkarte wird zunächst ein integrierter Schaltkreis auf einen Kartenträger aus Kunststoff aufgebracht. Danach wird entlang der Außenkanten der Chipkarte eine Sende-/Empfangsspule aufgebracht, die mit entsprechenden Anschlüssen des integrierten Schaltkreises verbunden wird. Eine solche Chipkarte ist beispielsweise aus der DE 44 10 732 A1 bekannt. Bei der gattungsgemäßen Chipkarte ist von Nachteil, daß die Herstellung aufwendig und teuer ist. Falls eine Chipkarte nicht richtig arbeitet, wird die fehlerhafte Chipkarte vernichtet.

Die DE 44 37 721 A1 zeigt ein elektronisches Modul zum Einbau in einen Datenträger, wobei das elektronische Modul einen auf einem Träger des Moduls angeordneten integrierten Schaltkreis aufweist, der leitend mit einer Spule für den berührungslosen Datenaustausch verbunden ist.

Es ist Aufgabe der Erfindung, einen Modulträger zum Einsatz in eine Chipkarte sowie eine stets zuverlässig arbeitende gattungsgemässe Chipkarte sowie ein Verfahren zu deren Herstellung bereitzustellen, die eine Herstellung der Chipkarte zuverlässig und mit wenig Aufwand gewährleisten.

Diese Aufgabe wird durch den Gegenstand der unabhängigen Anspruche gelöst. Vorteilhafte Ausgestaltungen ergeben sich aus den Unteransprüchen.

Gemäß der Erfindung sind die Datenverarbeitungsschaltung und die Verbindungsbaugruppe im Bereich wenigstens eines Modulträgers vorgesehen, und der Kartenträger weist einen Bereich zur Aufnahme des Modulträgers bzw. der Mcdulträger auf.

Die Erfindung beruht auf dem Grundgedanken, daß die Nachteile bei den gattungsgemäßen Chipkarten daher rühren, daß sich erst bei fertiggestellter Chipkarte überprüfen läßt, ob der integrierte schaltkreis richtig mit der Sende-/Empfangsspule zusammenarbeitet. Gemäß der Erfindung werden die für die Funktion der Chipkarte wesentlichen Teile, d.h. eine Funktionsbaugruppe getrennt von dem Kartenträger auf einem Modulträger hergestellt und erst bei der Endmontage von Kartenträger und Modulträger miteinander verbunden. Dadurch ist es möglich, zunächst die Funktionsbaugruppe auf deren Funktion hin zu überprüfen. Wenn feststeht, daß auf dieser die Datenverarbeitungsschaltung nicht richtig mit der Verbindungsbaugruppe zusammenarbeitet, dann kann die Funktionsbaugruppe vernichtet werden, ohne daß ein an sich verwendbarer Kartenträger mit vernichtet werden müßte. Darüber hinaus ist es möglich, die Herstellung der Funktionsbaugruppe zu beschleunigen, da der nur wenig Platz beanspruchende Modulträger das Vorsehen von kleineren und schnelleren Herstellungsvorrichtungen ermöglicht.

Gemäß der Erfindung ist der Modulträger fest mit der Chipkarte verbindbar, wobei der am Kartenträger vorgesehene Bereich zur Aufnahme des Modulträgers auch als Aussparung ausgebildet sein kann. Bei geeigneter Ausbildung von Modulträger und Aussparung kann gewährleistet werden, daß sich bereits beim Einsetzen des Modulträgers in die Aufnahme eine formschlüssige Verbindung ergibt, die nur noch fixiert werden muß.

Eine besonders vorteilhafte erfindungsgemäße Chipkarte ergibt sich dann, wenn die Verbindungsbaugruppe wenigstens eine Sende-/Empfangsspule aufweist, die bezüglich der Haupterstreckungsrichtung des Modulträgers auch in zwei unterschiedlichen Ebenen angeordnet sein kann. Dabei ist insbesondere vorgesehen, daß ein Bereich der Sende-/Empfangsspule auf einer Oberfläche des Modulträgers angeordnet ist, während ein anderer Bereich in einer Schicht im Inneren des Modulträgers angeordnet sein kann. Dies läßt sich besonders einfach durch eine zweilagige Metallisierung erreichen, wobei insbesondere ein sandwichartiger Aufbau des Modulträgers in Frage kommt. Dabei können die Bereiche der Sende/Empfangsspule auf einer Oberfläche des Modulträgers und im Inneren des Modulträgers planparallel angeordnet sein, wobei die einzelnen Bereiche durch Kontakte miteinander verbunden sind. Dies läßt sich besonders einfach durch Durchkontaktierungen im Bereich von Anschlüssen der jeweiligen Sende-/Empfangsspulen-Bereiche erreichen. Vorzugsweise sind die einzelnen Bereiche der Sende/Empfangsspule in Reihe geschaltet, da sich dann eine Sende/Empfangsspule ergibt, die mit einem hohen Wirkungsgrad ein externes Wechselfeld beeinflussen kann. Dabei ergibt sich ein besonders hoher Wirkungsgrad der Sende-/Empfangsspule dann, wenn die Übertragungseinrichtung, die oft ein Teil der Datenverarbeitungsschaltung ist, so ausgebildet ist, daß die Bereiche der Sende-/Empfangsspule zueinander in einer Resonanzphasenlage haltbar sind. Dies kann beispielsweise durch geeignetes Hinzuschalten von Kapazitäten und/oder Induktivitäten erfolgen, wobei dies vorzugsweise so erfolgt, daß die Resonanzfrequenzen der Bereiche der Sende/Empfangsspule jeweils übereinstimmen.

Abweichend davon oder in Ergänzung zu der vorgenannten Ausführungsform kann die Übertragungseinrichtung auch so ausgebildet sein, daß die Bereiche der Sende-/Empfangsspule zueinander synchronisiert betreibbar sind. Dies kann vorteilhafterweise so erfolgen, daß sich eine Verstärkung des von der Sende-/Empfangsspule ausgehenden Wechselfeldes ergibt. Dies ist für aktive Karten von Bedeutung, die ein Signal aussenden. Durch Anwendung einer Phasenschnitt-Technik kann ein Synchronisieren der Flankenlage auf den Bereichen der Sende-/Empfangsspule erreicht werden, und zwar derart, daß sich eine Verstärkung des von der Sende-/Empfangsspule erzeugten Wechselfeldes ergibt. Bei passiven Karten kann dadurch ein besonders hoher Kopplungsgrad zwischen Chipkarte und externer Datenverarbeitungsstation erreicht werden.

Eine weitere Verbesserung der Übertragungsqualität von Daten zwischen Chipkarte und Externer Datenverarbeitungsstation ergibt sich dann, wenn der Modulträger wenigstens einen als Spulenkern für die Sende-/Empfangsspule ausgebildeten Bereich aufweist. Dabei kann der Modulträger aus Kunststoff ausgebildet sein, in den permeables Material wie beispielsweise Ferrit eingelagert ist. Wenn das permeable Material als Vielzahl von Ferritpartikeln vorliegt, werden diese zum Zwecke der gegenseitigen Isolierung in einer Kunststoffmasse gebunden, die in dem Modulträger vorgesehen ist. Der so hergestellte Spulenkern dient zum Erreichen eines hohen Feldverstärkungsfaktors. Durch ein solches Dielektrikum können relative magnetische Permeabilitäten in der Größenordnung von 5.000 und somit hohe Flußdichten erreicht werden.

Die Erfindung betrifft auch ein Verfahren zum Herstellen einer Chipkarte, das die folgenden Schritte aufweist:
- Vorsehen eines Kartenträgers mit einer Aufnahme für einen Modulträger,
- Vorsehen eines erfindungsgemäßen Modulträgers mit einer Datenverarbeitungsschaltung und mit einer Verbindungsbaugruppe,
- Einbringen des Modulträgers in die Aufnahme, und
- Verbinden von Modulträger mit dem Kartenträger.

Durch das erfindungsgemäße Verfahren kann eine Chipkarte besonders einfach und kostengünstig hergestellt werden.

Die vorgenannten Herstellungsschritte zum Herstellen einer erfindungsgemäßen Chipkarte und/oder eines erfindungsgemäßen Modulträgers mit doppellagiger Sende-/Empfangsspule können selbstverständlich auch zum Herstellen von Chipkarten und/oder Modulträgern mit einer einzelnen Spulenlage angewendet werden. Darüber hinaus sind auch Verfahrensschritte möglich, die das Vorsehen einzelner oder Kombinationenen von Sachmerkmalen insbesondere gemäß den Ansprüchen 1 bis 13 umfassen können.

Die Erfindung ist anhand eines Ausführungsbeispiels in der Zeichnung näher veranschaulicht.
- Figur 1: zeigt einen Modulträger mit einer Datenverarbeitungsschaltung und mit einer Sende/Empfangsspule in der Draufsicht,
- Figur 2: zeigt einen Kartenträger in der Draufsicht,
- Figur 3: zeigt eine erfindungsgemäße Chipkarte mit dem Modulträger aus Figur 1 und mit dem Kartenträger aus Figur 2 in der Draufsicht,
- Figur 4: zeigt den Modulträger aus Figur 1 in der Ansicht von vorne, und
- Figur 5: zeigt ein Endlosband zur Herstellung der Modulträger aus Figur 1 in der Draufsicht.

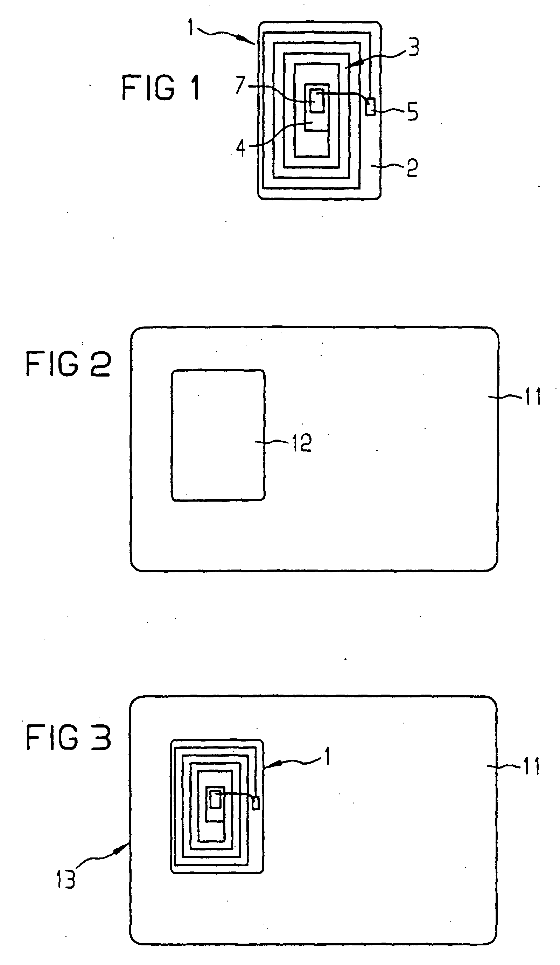

Figur 1 zeigt einen Modulträger 1 der erfindungsgemäßen Chipkarte. Der Modulträger 1 weist eine aus Kunststoff hergestellte Grundplatte 2 mit im wesentlichen rechteckigen Querschnitt auf. Dabei sind die Ecken der Grundplatte 2 abgerundet, wie in Figur 1 besonders deutlich zu sehen ist. Auf der Oberseite der Grundplatte 2 ist mittels Metallisierung eine Sende-/Empfangsspule 3 vorgesehen, wobei sich die Windungen der Sende-/Empfangsspule 3 ausgehend von einem in der Mitte der Grundplatte 2 vorgesehenen ersten Anschlußkontakt 4 im wesentlichen spiralförmig um den ersten Anschlußkontakt 4 herum bis zu einem zweiten Anschlußkontakt 5 erstrecken.

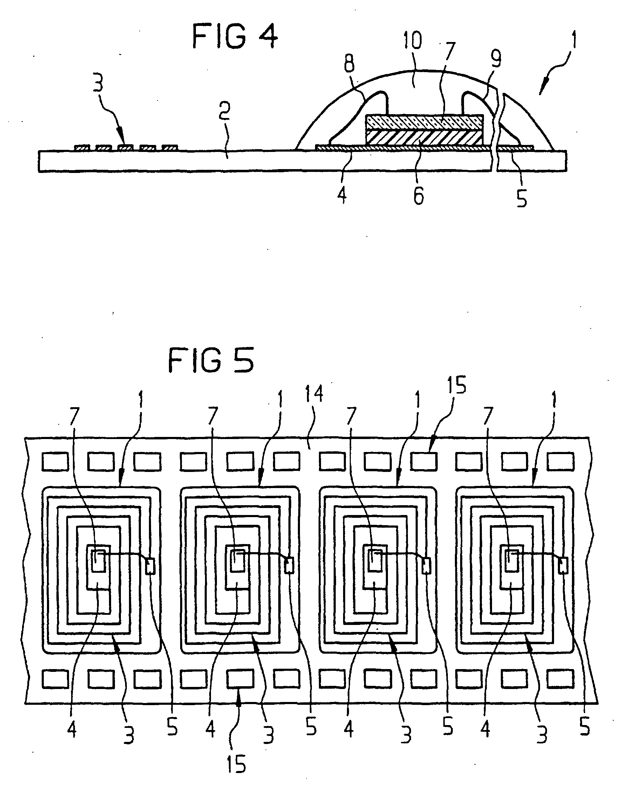

Wie man in Figur 4 am besten sieht, ist auf dem ersten Anschlußkontakt 1 mittels einer Isolierkleberschicht 6 ein integrierter Schaltkreis 7 angebracht. Der integrierte Schaltkreis 7 hat eine erste Anschlußleitung 8, die mit dem ersten Anschlußkontakt 4 verbunden ist, sowie eine zweite Anschlußleitung 9, die mit dem zweiten Anschlußkontakt 5 verbunden ist. In der in Figur 4 gezeigten Ansicht ist ein Bereich zwischen dem integrierten Schaltkreis 7 und dem zweiten Anschlußkontakt 5 aus dem Modulträger 1 herausgebrochen dargestellt, damit sich der Modulträger 1 in der Zeichnung einfacher darstellen läßt.

Wie man in Figur 4 ebenfalls gut sieht, ist der Modulträger 1 im Bereich des ersten Anschlußkontakts 4 und im Bereich des zweiten Anschlußkontakts 5 mit einer Abdeckschicht 10 aus einer thermisch härtbaren bzw. UV-härtbaren Masse abgedeckt.

Figur 2 zeigt einen Kartenträger 11 mit im wesentlichen rechteckiger Außenform, der eine rechteckige Ausnehmung 12 zur Aufnahme des Modulträgers 1 aus Figur 1 aufweist. Der Kartenträger 11 ist aus einer Kunststoffplatte hergestellt, die im wesentlichen die gleiche Stärke hat wie die Grundplatte 2 des Modulträgers 1. Die Ausnehmung 12 ist dabei so ausgeformt, daß der Modulträger 1 formschlüssig in die Ausnehmung 12 eingesetzt werden kann.

Figur 3 zeigt eine erfindungsgemäße Chipkarte 13, die aus dem Modulträger 1 gemäß den Figuren 1 und 4 und aus dem Kartenträger 11 gemäß Figur 2 zusammengesetzt ist. Wie man-in dieser Ansicht besonders gut sieht, ist der Modulträger 1 so in die Ausnehmung 12 eingesetzt, daß sich eine formschlüssige Verbindung ergibt. In diesem Zustand ist der Modulträger 1 mit dem Kartenträger 11 zusätzlich über eine Klebung verbunden.

Sowohl die Grundplatte 2 als auch der Kartenträger 11 sind aus einem Kunststoff wie glasfaserverstärktes Epoxydharz, PVC, PET, PC und/oder ABS herstellbar. Die Sende/Empfangsspule 3 ist in Ätz-, Wickel-, Verlege- oder Drucktechnik auf die Grundplatte 2 aufbringbar.

Wie man besonders gut in Figur 5 sieht, werden erfindungsgemäße Modulträger 1 in einem Endlosbandverfahren gefertigt, wobei ein Endlosband 14 aus einem Kunststoff vorgesehen ist, das an beiden Längsseiten je eine Transportlochung 15 aufweist. Aufgrund des Vorsehens der Transportlochung 15 läßt sich das Endlosband 14 besonders einfach durch bei der Herstellung der erfindungsgemäßen Modulträger 1 verwendete Maschinen führen.

Nach erfolgter Fertigstellung des Endlosbandes 14 mit darauf vorgesehenen Modulträgern 1 werden diese einzeln geprüft und anschließend durch ein Stanzverfahren aus dem Endlosband 14 herausgelöst. In einem weiteren, hier nicht dargestellten Verfahrensschritt werden die auf ihre Funktion hin überprüften Modulträger 1 in bereitstehende Kartenträger 11 eingesetzt und dadurch die erfindungsgemäßen Chipkarten fertiggestellt.

Mit dem erfindungsgemäßen Modulträger ist die Sende/Empfangsspule 3 mit einem Halbleiterchip 7 in einem einzigen Modul 1 zusammengefaßt, das in einer Massenfertigung auf einfache Weise herstellbar ist. Erst in einem abschließenden Arbeitsschritt werden die erfindungsgemäßen Modulkörper 1 in den Kartenträger 11 eingesetzt. Dabei kann der Halbleiterchip 7 sowohl nach einer herkömmlichen Wire-Bond-Technik als auch mit einer Flip-Chip-Technik auf dem erfindungsgemäßen Modulträger 2 befestigt werden.

## Patentansprüche

1. Modulträger zum Einsatz in einer Chipkarte mit einer Übertragungseinrichtung, die wenigstens eine Sende/Empfangsspule (3) aufweist, die Bereiche aufweist, die bezüglich der Haupterstreckungsrichtung des Modulträgers in wenigstens zwei unterschiedlichen, übereinander angeordneten Ebenen angeordnet sind,
**dadurch gekennzeichnet, daß**
die Übertragungseinrichtung so ausgebildet ist, daß die Bereiche der Sende-/Empfangsspule (3) zueinander in einer Resonanzphasenlage haltbar sind.

2. Modulträger zum Einsatz in einer Chipkarte mit einer Übertragungseinrichtung, die wenigstens eine Sende/Empfangsspule (3) aufweist, die Bereiche aufweist, die bezüglich der Haupterstreckungsrichtung des Modulträgers in wenigstens zwei unterschiedlichen Ebenen angeordnet sind,
**dadurch gekennzeichnet, daß**
die Übertragungseinrichtung so ausgebildet ist, daß die Bereiche der Sende-/Empfangsspule (3) zueinander synchronisiert betreibbar sind.

3. Chipkarte mit einem Kartenträger, auf dem eine Datenverarbeitungsschaltung sowie eine Verbindungsbaugruppe zur kontaktlosen Übermittlung von Daten zwischen der Datenverarbeitungsschaltung und einer externen Datenverarbeitungsstation vorgesehen sind, wobei die Datenverarbeitungsschaltung (7) und die Verbindungsbaugruppe (3) im Bereich wenigstens eines Modulträgers (1) vorgesehen sind, und wobei der Kartenträger (11) einen Bereich (12) zur Aufnahme des Modulträgers (1) bzw. der Modulträger aufweist, **dadurch gekennzeichnet, daß** der Modulträger gemäß Anspruch 1 und/oder Anspruch 2 vorgesehen ist.

4. Chipkarte nach Anspruch 3, **dadurch gekennzeichnet, daß** die Chipkarte so ausgebildet ist, daß der bzw. die Modulträger (1) fest mit dem Kartenträger (11) verbindbar ist bzw. sind.

5. Chipkarte nach Anspruch 3 oder Anspruch 4, **dadurch gekennzeichnet, daß** der Bereich zur Aufnahme des Modulträgers (1) als Aussparung (12) ausgebildet ist.

6. Cipkarte nach einem der Ansprüche 3 bis 5, **dadurch gekennzeichnet, daß** die Verbindungsbaugruppe wenigstens eine Sende-/Empfangsspule (3) aufweist.

7. Chipkarte nach Anspruch 6, **dadurch gekennzeichnet, daß** die Sende-/Empfangsspule bezüglich der Haupterstrekkungsrichtung des Modulträgers in zwei unterschiedlichen Ebenen angeordnet ist.

8. Chipkarte nach Anspruch 7, **dadurch gekennzeichnet, daß** ein Bereich der Sende-/Empfangsspule auf einer Oberfläche des Modulträgers angeordnet ist.

9. Chipkarte nach Anspruch 7 oder Anspruch 8, **dadurch gekennzeichnet, daß** ein Bereich der Sende-/Empfangsspule im Inneren des Modulträgers angeordnet ist.

10. Chipkarte nach Anspruch 8 und Anspruch 9, **dadurch gekennzeichnet, daß** die Bereiche der Sende-/Empfangsspule auf einer Oberfläche des Modulträgers und im Inneren des Modulträgers durch Kontakte miteinander verbunden sind.

11. Chipkarte nach Anspruch 11, **dadurch gekennzeichnet, daß** die Bereiche der Sende-/Empfangsspule auf einer Oberfläche des Modulträgers und im Inneren des Modulträgers in Reihe geschaltet sind.

12. Chipkarte nach einem der vorhergehenden Ansprüche, **dadurch gekennzeichnet, daß** der Modulträger wenigstens einen als Spulenkern ausgebildeten Bereich aufweist.

13. Chipkarte nach Anspruch 12, **dadurch gekennzeichnet, daß** der Modulträger aus Kunststoff ausgebildet ist, in den ein permeables Material eingelagert ist.

14. Verfahren zum Herstellen einer Chipkarte gemäß einem der Ansprüche 3 bis 13, mit den folgenden Schritten:
- Vorsehen eines Kartenträgers (11) mit einer Aufnahme für einen Modulträger (1),
- Vorsehen eines Modulträgers (1) gemäß Anspruch 1 und/oder Anspruch 2, wobei der Modulträger (1) eine Datenverarbeitungsschaltung (7) und eine Verbindungsbaugruppe (3) aufweist,
- Einbringen des Modulträgers (1) in die Aufnahme, und
- Verbinden von Modulträger (1) mit dem Kartenträger (11).

## Claims

1. Module carrier for use in a smart card having a transmission device which has at least one transmission/reception coil (3) which has regions which, in relation to the main direction of extension of the module carrier, are arranged in at least two different planes arranged above one another,
**characterized in that**
the transmission device is designed such that the regions of the transmission/reception coil (3) can be kept at a resonant phase angle with respect to one another.

2. Module carrier for use in a smart card having a transmission device which has at least one transmission/reception coil (3) which has regions which, in relation to the main direction of extension of the module carrier, are arranged in at least two different planes,
**characterized in that**
the transmission device is designed such that the regions of the transmission/reception coil (3) can be operated so as to be synchronized to one another.

3. Smart card having a card carrier on which a data processing circuit and a connection assembly for the contactless transmission of data between the data processing circuit and an external data processing station are provided, where the data processing circuit (7) and the connection assembly (3) are provided in the region of at least one module carrier (1), and where the card carrier (11) has a region (12) for holding the module carrier (1) or the module carriers, **characterized in that** the module carrier is provided in accordance with Claim 1 and/or Claim 2.

4. Smart card according to Claim 3, **characterized in that** the smart card is designed such that the module carrier(s) (1) can be firmly connected to the card carrier (11).

5. Smart card according to Claim 3 or Claim 4,
**characterized in that** the region for holding the module carrier (1) is in the form of a cutout (12).

6. Smart card according to one of Claims 3 to 5,
**characterized in that** the connection assembly has at least one transmission/reception coil (3).

7. Smart card according to Claim 6, **characterized in that**, in relation to the main direction of extension of the module carrier, the transmission/reception coil is arranged in two different planes.

8. Smart card according to Claim 7, **characterized in that** one region of the transmission/reception coil is arranged on a surface of the module carrier.

9. Smart card according to Claim 7 or Claim 8,
**characterized in that** one region of the transmission/reception coil is arranged inside the module carrier.

10. Smart card according to Claim 8 and Claim 9,
**characterized in that** the regions of the transmission/reception coil on a surface of the module carrier and inside the module carrier are connected to one another by contacts.

11. Smart card according to Claim 11, **characterized in that** the regions of the transmission/reception coil on a surface of the module carrier and inside the module carrier are connected in series.

12. Smart card according to one of the preceding claims, **characterized in that** the module carrier has at least one region which is in the form of a coil core.

13. Smart card according to Claim 12, **characterized in that** the module carrier is formed from plastic into which a permeable material is incorporated.

14. Method for manufacturing a smart card according to one of Claims 3 to 13, having the following steps:
- a card carrier (11) having a holder for a module carrier (1) is provided,
- a module carrier (1) according to Claim 1 and/or Claim 2 is provided, the module carrier (1) having a data processing circuit (7) and a connection assembly (3),
- the module carrier (1) is inserted into the holder, and
- the module carrier (1) is connected to the card carrier (11).

## Revendications

1. Support de module destiné à être utilisé dans une carte à puce comportant un dispositif de transmission, lequel présente au moins une bobine émettrice/réceptrice (3) qui présente des zones qui sont disposées dans au moins deux plans superposés différents par rapport au sens d'extension principal du support de module, **caractérisé en ce que** le dispositif de transmission est configuré de telle manière à ce que les zones de la bobine émettrice/réceptrice puissent être maintenues l'une par rapport à l'autre dans une relation de phases de résonance.

2. Support de module destiné à être utilisé dans une carte à puce comportant un dispositif de transmission, lequel présente au moins une bobine émettrice/réceptrice (3) qui présente des zones qui sont disposées dans au moins deux plans différents par rapport au sens d'extension principal du support de module, **caractérisé en ce que** le dispositif de transmission est configuré de telle manière à ce que les zones de la bobine émettrice/réceptrice puissent fonctionner de façon synchrone l'une par rapport à l'autre.

3. Carte à puce avec un support de carte sur laquelle est prévu un circuit de traitement de données ainsi qu'un module de connexion pour la transmission sans contact de données entre le circuit de traitement de données et un poste de traitement de données externe, le circuit de traitement de données (7) et le module de connexion (3) étant prévus dans la zone d'au moins un support de module (1), le support de carte (11) présentant une zone (12) pour recevoir le support de module (1) ou les supports de module, **caractérisée en ce que** le support de module est prévu conformément à la revendication 1 et/ou la revendication 2.

4. Carte à puce selon la revendication 3, **caractérisée en ce que** la carte à puce est configurée de telle manière que le ou les supports de module (1) puissent être ou sont fixés à demeure avec le support de carte (11).

5. Carte à puce selon la revendication 3 ou la revendication 5, **caractérisée en ce que** la zone destinée à recevoir le support de module (1) est réalisée sous la forme d'un évidement (12).

6. Carte à puce selon l'une des revendications 3 à 5, **caractérisée en ce que** le module de connexion présente au moins une bobine émettrice/réceptrice (3).

7. Carte à puce selon la revendication 6, **caractérisée en ce que** la bobine émettrice/réceptrice est disposée dans deux plans différents par rapport au sens d'extension principal du support de module.

8. Carte à puce selon la revendication 7, **caractérisée en ce qu'**une zone de la bobine émettrice/réceptrice est disposée sur une surface du support de module.

9. Carte à puce selon la revendication 7 ou la revendication 8, **caractérisée en ce qu'**une zone de la bobine émettrice/réceptrice est disposée à l'intérieur du support de module.

10. Carte à puce selon la revendication 8 et la revendication 9, **caractérisée en ce que** les zones de la bobine émettrice/réceptrice sont reliées entre elles par des contacts sur une surface du support de module et à l'intérieur du support de module.

11. Carte à puce selon la revendication 11, **caractérisée en ce que** les zones de la bobine émettrice/réceptrice sont branchées en série sur une surface du support de module et à l'intérieur du support de module.

12. Carte à puce selon l'une des revendications précédentes, **caractérisée en ce que** le support de module présente au moins une zone réalisée sous la forme d'un noyau de bobine.

13. Carte à puce selon la revendication 12, **caractérisée en ce que** le support de module est réalisé en matière plastique dans laquelle est incorporé un matériau perméable.

14. Procédé pour réaliser une carte à puce selon l'une des revendications 3 à 13, comprenant les étapes suivantes :
- dotation d'un support de carte (11) d'un logement pour un support de module (1),
- dotation d'un support de module (1) selon la revendication 1 et/ou la revendication 2 d'un circuit de traitement de données (7) et d'un module de connexion (3),
- mise en place du support de module (1) dans le logement, et
- raccordement du support de module (1) avec le support de carte (11).
